# EUROPEAN PATENT APPLICATION

(11) **EP 1 610 344 A1**
(43) Date of publication of application: **28.12.2005**
(21) Application number: 05106384.0
(22) Date of filing: 17.02.2003
(51) Int. Cl.: G11C 16/22, G11C 16/20

(54) **Product and method preventing incorrect storage of data in case of power-down**

(30) Priority: 05.03.2002 WO PCT/SG02/00041
(62) Divisional of application: 03702925.3
(71) Applicant: Koninklijke Philips Electronics N.V., 5621 BA Eindhoven (NL)
(72) Inventor: Win, Naing Philips Int. Prop. & Standards, 5600 AE, Eindhoven (NL); Cai, Jun Philips Int. Prop. & Standards, 5600 AE, Eindhoven (NL); Jimson, Joseph Philips Int. Prop. & Standards, 5600 AE, Eindhoven (NL); Lam, Weng, K. Philips Int. Prop. & Standards, 5600 AE, Eindhoven (NL)
(74) Representative: Groenendaal, Antonius W. M.

(57) **Abstract**

The product has a power supply (P2) and a processor (P). The processor (P) has an input (PDD) for receiving a power-down signal indicating a status of the power supply (P2) and another input (Q) connected to another supply. The product also has a non-volatile memory (M) for storing data supplied by the processor (P) and having a device code. The processor (P) has an algorithm to detect a power-down status of the power supply (P2) by repeatedly checking the power-down signal and, upon detection that the power-down signal has a value (S0) corresponding to the power-down status, to complete an ongoing writing operation and stop the storage of data. The processor (P) is adapted for thereafter selecting a device code deviating from the device code of the non-volatile memory (M) to prevent incorrect storage of data.

## Description

The invention relates to a product comprising a power supply, a processor having an input for receiving a power-down signal indicating a status of the power supply and having another input coupled to another supply, and a non-volatile memory for storing data supplied by the processor. The invention also relates to a method of preventing incorrect storage of data in a product, which product comprises a power supply, a processor having an input for receiving a power-down signal indicating a status of the power supply, and a non-volatile memory for storing data supplied by the processor.

An embodiment of such a product is known from US 5,896,338. The known product has a circuit, which abruptly stops writing operations to a non-volatile memory when receiving the power-down signal by sending a signal to the non-volatile memory.

As will be known to persons skilled in the art, many important data are stored in current products in the non-volatile memory, hereinafter also called NVM, which is frequently accessed by the processor. This leads to an increased risk of NVM corruption when NVM writing would happen during a power-down phase. Therefore, ensuring integrity of NVM data during the power-down phase is a very critical issue in products. A standard software solution as used with processors of type SAA56XX keeps the software waiting in an infinite loop as soon as the power-down signal has a value corresponding to the power-down status. One would expect that no NVM read/write activity would happen thereafter. However, experiments showed that there is a risk that NVM writing does take place when a supply voltage of the other supply drops to a level of around 2.2V. In other words, the standard software solution cannot fully protect the NVM from becoming corrupted.

Alternatively, the product may have a circuit as in the known product. However, it is a drawback of the known product that data in the NVM become corrupted when an ongoing writing operation from the processor to the NVM is interrupted.

JP 05 342 115 A discloses a processor receiving power from a maintaining power supply which is capable of continuing supplying an output voltage during a predetermined length of time after the main power source is interrupted. The predetermined length of time is determined by the energy stored in a capacitor coupled to an input of the maintaining power supply. When an interruption of the main power supply is detected, an interruption signal is sent to the processor, which then fmishes first an ongoing updating of data of the memory.

It is an object of the invention to provide a product of the kind described in the opening paragraph, which has simple yet effective means to obviate NVM data corruption during the power-down phase.

The invention is defined by the independent claims. The dependent claims define advantageous embodiments.

The object is realized in that the processor is adapted for detecting a power-down status of the power supply by repeatedly checking the power-down signal and, upon detection that the power-down signal has a value corresponding to the power-down status, completing an ongoing writing operation and stopping the storage of data. In this way, the processor is adapted to complete an ongoing writing operation after detection of the power-down status, thereby avoiding an abrupt interruption, which would result in data corruption. Thereafter, all writing to the NVM is stopped before the supply voltage of the other supply has dropped below a value at which the processor operates unreliably.

In addition, the non-volatile memory has a device code and the algorithm comprises a step of selecting a device code deviating from the device code of the non-volatile memory after the power-down status has been detected. As a result, the read/write activities are redirected to a non-existing address before the processor reaches an undefined stage during the power-down phase.

It is a further advantage, if the algorithm comprises a step of putting the processor in an infinite waiting loop. In the mentioned embodiments only additional software is needed. Extra hardware costs to discharge the supply are avoided because the processor continues to operate during the power-down phase, thereby discharging the other supply.

Thereby the problems described below are avoided.

When stopping the operation of the processor completely, via a power-down mode, thereby ensuring that all random software activity, which might cause NVM corruption during the power-down phase, is stopped, it is no longer drawing current from its supply. As a result, the supply voltage of the processor decreases only slowly. If the power is supplied again to the product while the supply voltage of the processor has not yet decreased below a predetermined level, the processor does not restart until a subsequent cycle of the power-down phase of a sufficiently long duration has been completed. The predetermined level may be a value as mentioned in datasheets of the processor or a value determined by experiments.

The product may be any product in which a non-volatile memory is present, like a television, a video, an audio a computer or a communication product.

These and other aspects of the product and the method of the invention will be further elucidated and described with reference to the drawings, in which:
Fig. 1 shows a block diagram of the product
Fig. 2 shows timing diagrams of the known product
Figs. 3 and 4 show the time difference between the solution of using the power-down mode and not using the power-down mode.

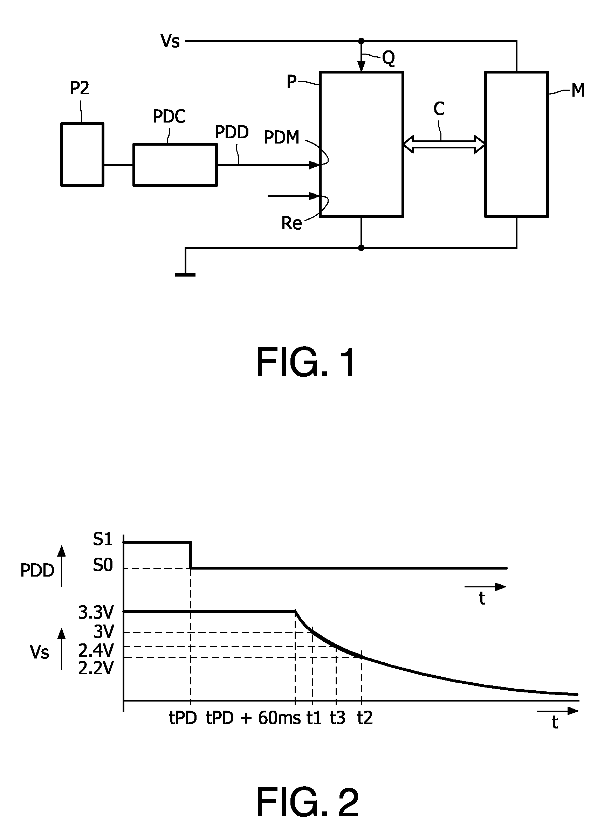

The product of Fig. 1 has a power supply P2, being the main power supply of the product. A processor P is connected via input Q to another supply having a supply voltage Vs. Also a NVM M for storing data supplied by the processor (P) is connected to the other supply. Via connections C, data, enable signals and clock signals are transferred between the processor P and the NVM M. A power-down detection circuit PDC is coupled to the power supply P2 to detect a status of the power supply P2 and transmit a power-down signal PDD to a power-down input PDM of the processor P. The processor has also a power-on reset input Re which keeps the processor P on hold during a start-up phase until the supply voltage Vs has reached a value ensuring proper functioning of the processor P.

A typical operating range of the NVM M is from 2.5V to 3.6V while for a processor P of the type SAA56XX the operating range is from 3.0 to 3.6V. However, experiments have shown that the processor P is still operating until 2.2V if a power-on reset signal is absent or delayed at the power-on reset input Re of the processor P during a power-down phase. The reset signal cannot be used to stop the operation of the processor P during a power-down phase, because it would stop the operation too late and abruptly without allowing a proper shut-down of the software activity.

As is shown in the graph of the supply voltage Vs versus time t in Fig. 2, if data are written from the processor P to the NVM M via the connections C between times t1 and t2, data inside the NVM M may be corrupted because the processor P does not operate reliably below 3.0V. Below 3.0 V, algorithms might not work correctly anymore in the processor P and, moreover, data could be corrupted, resulting in a risk of undesired writing of incorrect data to the NVM M. To address this risk, the power-down mode provided by the processor P totally stops the software activity before the supply voltage Vs enters the region where the processor P does not operate reliably anymore. The power-down mode is controlled by the power-down signal PDD. If the power supply P2 is operating, the power-down signal has a power-on value S1. If the power supply P2 stops, the power-down signal has a power-down value S0, indicating that the power supply P2 is in the power-down status. In order to enable correct stopping of the software activity, the other supply is adapted to supply the typical operating voltage, being 3.3V for the SAA56XX type of processors, during a period of about 60ms after time tPD, being the time when the power-down signal has a transition from the power-on value S1 to the power-down value S0.

The algorithm is incorporated in the processor and comprises the steps of:
- checking whether the power-down signal PDD has the power-down value S0.
- if so, a second check is done after a predetermined time delay, for example 10 ms. If not, the routine is restarted.
- if, also during the second check, the power-down value S0 is detected, then upon completion of an ongoing writing operation the power-down mode is started by the processor P which comprises putting the software in an infinite waiting loop and thereafter stopping the operation of the processor P. If the power-down value S0 is not detected, the routine is restarted.

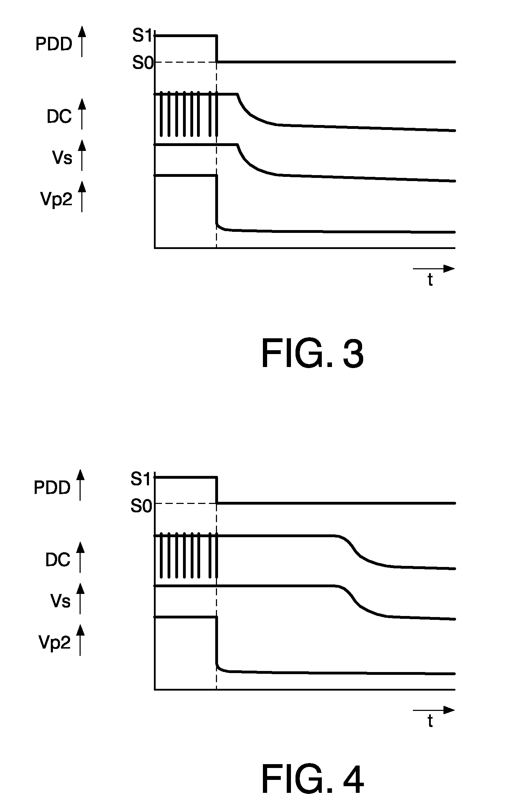

The side effect of the power-down mode is that it takes a longer time to discharge the other supply as the power-down mode consumes a very low power. Figs. 3 and 4 show the time difference between the solution of using the power-down mode and not using the power-down mode. As is known from the processor specification, the reset input Re is coupled to the other supply. If the power supply P2 restarts before a time t3 as shown in Fig. 2, which is before supply voltage Vs has dropped below a value of 2.4V for the processor types SAA56xx, the reset signal at the power-on reset input Re keeps the processor P in the power-down mode.

In Figs. 3 and 4, the following waveforms are shown as a function of time t from top to bottom: power-down signal PDD, data Dc transmitted via the connections C, the supply voltage Vs, and the voltage Vp2 of the power supply P2.

In accordance with the present invention, use is made of the fact that the processor P must initiate a start condition to start IIC communication between the processor P and the NVM M, followed by a 7-bit device code, and a 1-bit read/write designator before data can be written to the NVM M. The NVM M will respond only when the device code, hereinafter also called device select code, matches its own one. If the device code is intentionally changed during the power-down phase to a code corresponding to a non-existing device, data will no longer be accepted by the NVM M. By doing so, a potential NVM M data corruption during the power-down phase can be prevented.

The algorithm applied in this embodiment in the processor P is the same as the previously described algorithm, except for the last step. Instead of starting the power-down mode, the device select code for the data addressed to the NVM is re-addressed to device select code zero, being a code for a non-existing device.

In a modification, the infinite waiting loop is started after the data re-addressing to provide extra security that unwanted writing activities are obviated during the power-down phase.

The invention has been tested with two products in the following operating conditions: Power supply P2 is switched on and off in cycles having a power-on phase of 30 s followed by a power-down phase of 30s. To clearly show the effectiveness, the power-on reset signal was modified in such a way that the reset signal was not generated during the power-down phase. The test results given in Table 1 clearly show the effectiveness of the algorithm.

**Table 1**

| test period: | Solution applied: | Result: |
|---|---|---|
| Day 1 to Day 15 | NVM data re-addressing solution without infinite waiting loop according to the second embodiment | No NVM data corrupted |
| Day 16 | Infinite waiting loop method without NVM data re-addressing solution according to the known product | NVM data corrupted twice within two hours |
| Day 16 to Day 35 | Re-tested the NVM data re-addressing solution with infinite waiting loop according to the modification of the second embodiment | No NVM data corrupted |

The algorithm of the invention combined with the modification proves to be a very simple and effective means to obviate the NVM M data corruption. No additional hardware circuitry is required, resulting in a very cost-effective solution.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention can be implemented by means of hardware comprising several distinct elements, and by means of a suitably programmed computer. In the device claim enumerating several means, several of these means can be embodied by one and the same item of hardware. The mere fact that certain measures are recited in mutually different dependent claims does not indicate that a combination of these measures cannot be used to advantage.

## Claims

1. A product comprising
a power supply (P2);
a processor (P) having an input for receiving a power-down signal (PDD) indicating a status of the power supply (P2) and having another input (Q) coupled to another supply; and
a non-volatile (M) for storing data supplied by the processor (P) and having a device code,
the processor (P) being adapted for:
detecting a power-down status of the power supply (P2) by repeatedly checking the power-down signal;
upon detection that the power-down signal (PDD) has a value (SO) corresponding to the power-down status,
completing an ongoing writing operation, and
stopping the storage of further data, **characterized in that** the processor (P) is further adapted for thereafter selecting a device code deviating from the device code of the non-volatile memory (M).

2. A product as claimed in claim 1, **characterized in that** the processor (P) is further adapted for starting a power-down mode of the processor (P).

3. A product as claimed in claim 1, the algorithm comprising a step of putting the processor (P) in an infinite waiting loop.

4. A method of preventing incorrect storage of data in a product, which product comprises:
a power supply (P2);
a processor (P) having an input for receiving a power-down-signal (PDD) indicating a status of the power supply (P2) and having another input (Q) coupled to another supply; and
a non-volatile memory (M) for storing data supplied by the processor (P), the method comprising the steps of:
detecting a power-down status of the power supply (P2) by repeatedly checking the power-down signal (PDD);
upon detection that the power-down signal (PDD) has a value (SO) corresponding to the power-down status, completing an ongoing writing operation, and
stopping the storage of data; **characterized by** the step of selecting a device code deviating from the device code of the non-volatile memory (M).
